# EUROPEAN PATENT SPECIFICATION

(11) **EP 2 626 897 B1**
(45) Date of publication and mention of the grant of the patent: **15.09.2021**
(21) Application number: 11830896.4
(22) Date of filing: 05.10.2011
(51) Int. Cl.: H01L 23/12, H01L 23/48, H01L 23/485, H01L 23/538, H01L 23/66, H01L 23/367, H01L 23/498, H01L 25/065, H01L 23/49

(54) **TRANSMISSION LINE TRANSITION HAVING VERTICAL STRUCTURE AND SINGLE CHIP PACKAGE USING LAND GRID ARRAY JOINING**
ÜBERTRAGUNGSLEITUNGSÜBERGANG MIT EINER VERTIKALEN STRUKTUR UND EINZELCHIP-PAKET MIT LANDGITTER-ARRAYVERBINDUNG
TRANSITION DE LIGNE DE TRANSMISSION PRÉSENTANT UNE STRUCTURE VERTICALE ET BOÎTIER À PUCE UNIQUE UTILISANT UNE JONCTION DE BOÎTIER À MATRICE DE PLOTS

(30) Priority: 05.10.2010 KR 20100096885
(43) Date of publication of application: 14.08.2013
(73) Proprietor: Samsung Electronics Co., Ltd., Gyeonggi-do 443-742 (KR)
(72) Inventor: JUNG, Dong-Yun, Anyang-si Gyeonggi-do 431-752 (KR); CHOI, Sung-Tae, Hwaseong-si Gyeonggi-do 445-732 (KR); KIM, Young-Hwan, Hwaseong-si Gyeonggi-do 445-735 (KR); CHOI, Jung-Han, Incheon 405-221 (KR); KIM, Ji-Hoon, Gunpo-si Gyeonggi-do 435-020 (KR); LEE, Jei-Young, Yongin-si Gyeonggi-do 448-785 (KR); LEE, Dong-Hyun, Anyang-si Gyeonggi-do 430-041 (KR)
(74) Representative: Grünecker Patent- und Rechtsanwälte PartG mbB
(86) International application number: PCT/KR2011/007359
(87) International publication number: WO 2012/047011

(56) References cited:
- JP-A- 2007 129 304
- KR-A- 20080 077 934
- KR-A- 20080 102 270
- KR-B1- 100 656 300
- US-A1- 2003 111 714
- US-A1- 2005 030 231
- US-A1- 2007 013 051
- US-A1- 2007 040 735
- US-A1- 2010 001 906

## Description

### BACKGROUND OF THE INVENTION

### 1. Field of the Invention

The present invention relates to an apparatus for providing a single chip package minimizing Radio Frequency (RF) performance deterioration by reducing parasitic inductance occurring in the package as well as achieving low costs and miniaturization when mass-producing a product.

### 2. Description of the Related Art

A conventional single chip package couples a substrate of an RF band with a Printed Circuit Board (PCB) via a Ball Grid Array (BGA) technology that uses a ball having a height of about 0.6∼1 mm to form a single chip package.

This single chip package requires additional external processes such as ball forming, ball attaching, ball molding, etc. in an aspect of production. In addition, for maintaining the size of a ball and a predetermined interval, a package size increases and an attached ball may be detached, so that the single chip package has disadvantage in shipment and handling.

Also, in an RF band circuit of the single chip package, inductance generated from a ball for power supply and a ground generates performance deterioration and characteristic change such as gain reduction and frequency movement in an aspect of performance, and the ground should pass through a ball, so that the single chip package has a difficulty in radiation of heat.

Known devices in the art will be described below. According to JP 2007-129304 A there is provided a high frequency wireless module that can be inexpensively manufactured by downsizing the module shape and increasing the number of boards manufactured at a time in the case of manufacturing the module boards in a multiple board state.

Another multichip circuit module is provided according to US 2007/0013051 A1 that comprises at least one carrier substrate and at least one semiconductor chip arranged on the carrier substrate and in electrical contact therewith.

With respect to US 2005/0030231 A1 there is disclosed a high frequency circuit module, in which RF circuit parts are mounted on both sides of a hard multilayer dielectric substrate. A transmission line for connecting these RF circuit parts is constructed by a via group including a periodical structure or a via having a coaxial structure perpendicular to faces of the multilayer dielectric substrate.

An example of RF integrated circuit packages that have characteristics suitable for mass production is disclosed in accordance to US 2010/0001906 A1.

In connection to US 2003/0111714 A1 there is known a surface mount ceramic package with conductive pads that are available for direct connection with traces on the printed circuit board.

A further high frequency package is provided by US 2007/0040735 A1 wherein a multilayer dielectric substrate includes a first signal via, a second signal via, an internal-layer signal line, an internal-layer ground conductor and ground vias.

### SUMMARY OF THE INVENTION

An aspect of the present invention is to address at least the above-mentioned problems and/or disadvantages and to provide at least the advantages described below. Accordingly, an aspect of the present invention is to provide a single chip package using Land Grid Array (LGA) coupling according to the independent claims. Preferred embodiments are depicted in the dependent claims.

Another aspect of the present invention is to provide a single chip package wherein a path for power supply and a ground is short, and a signal is transmitted in a coaxial shape or in a Co-Planar Waveguide guide (CPW) shape, so that parasitic inductance is minimized and performance of an RF chip does not deteriorate and a characteristic does not change.

Still another aspect of the present invention is to provide an RF single chip package having excellent performance in heat radiation since a multi-layer substrate and a mainboard are directly connected via a pad.

In accordance with an aspect of the present invention, a single chip package using Land Grid Array (LGA) coupling is provided. The package includes a multi-layer substrate having at least one substrate layer, having at least one first chip region and at least one second chip region in a lowermost substrate layer, configuring a transmission line transition of a vertical structure for transmitting a signal from at least one integrated circuit chip coupled in the first chip region in a coaxial shape or in a Co-Planar Waveguide guide (CPW) shape, and having an LGA coupling pad for connecting with a Printed Circuit Board (PCB) in the lowermost layer, the at least one integrated circuit chip coupled in the first chip region and the second chip region, and the PCB connected with the multi-layer substrate using the LGA coupling via the LGA coupling pad.

In accordance with another aspect of the present invention, a single chip package using Land Grid Array (LGA) coupling is provided. The package includes a multi-layer substrate having at least one substrate layer, having at least one chip region in a lowermost substrate layer, configuring a transmission line transition of a vertical structure for transmitting a signal from at least one integrated circuit chip coupled in the chip region in a coaxial shape or in a Co-Planar Waveguide guide (CPW) shape, and having an LGA coupling pad for connecting with a Printed Circuit Board (PCB) in the lowermost layer, the at least one integrated circuit chip coupled in the chip region, and the PCB connected with the multi-layer substrate using the LGA coupling via the LGA coupling pad.

Other aspects, advantages and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features and advantages of certain exemplary embodiments of the present invention will be more apparent from the following description taken in conjunction with the accompanying drawings in which:
FIG. 1 is a view illustrating a single chip package using LGA coupling according to an embodiment of the present invention;
FIG. 2 is a view illustrating a multi-layer substrate before SMT according to an embodiment of the present invention;
FIG. 3 is a view illustrating a connection structure of a mainboard and a multi-layer substrate according to an example not forming part of the present invention but useful for understanding it;
FIG. 4 is a view illustrating a connection structure of a mainboard and a multi-layer substrate according to another example not forming part of the present invention but useful for understanding it;
FIG. 5 is a view illustrating a connection structure of a mainboard and a multi-layer substrate according to further another example not forming part of the present invention but useful for understanding it;
FIG. 6 is a view illustrating a connection structure of a mainboard and a multi-layer substrate according to still another an example not forming part of the present invention but useful for understanding it;
FIG. 7 is a view illustrating a connection structure of a mainboard and a multi-layer substrate according to yet another embodiment of the present invention;
FIG. 8 is a view illustrating a connection structure of a mainboard and a multi-layer substrate according to yet still another example not forming part of the present invention but useful for understanding it;
FIG. 9 is a view illustrating a connection structure of a mainboard and a multi-layer substrate according to yet further another example not forming part of the present invention but useful for understanding it;
FIG. 10 is a view illustrating a connection structure of a mainboard and a multi-layer substrate according to still yet another example not forming part of the present invention but useful for understanding it;
FIG. 11 is a view illustrating a connection structure of a mainboard and a multi-layer substrate according to still yet further another embodiment of the present invention;
FIG. 12 is a view illustrating a connection structure of a mainboard and a multi-layer substrate according to yet still another example not forming part of the present invention but useful for understanding it;
FIG. 13 is a view illustrating a connection structure of a mainboard and a multi-layer substrate according to yet still further another example not forming part of the present invention but useful for understanding it; and
FIG. 14 is a view illustrating a connection structure of a mainboard and a multi-layer substrate according to yet another embodiment of the present invention.

Throughout the drawings, like reference numerals will be understood to refer to like parts, components and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims. It includes various specific details to assist in that understanding but these are to be regarded as merely exemplary. Accordingly, those of ordinary skill in the art will recognize that various changes and modifications of the embodiments described herein can be made. Also, descriptions of well-known functions and constructions are omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention are provided for illustration purpose only and not for the purpose of limiting the invention as defined by the appended claims.

Exemplary embodiments of the present invention provide a single chip package using LGA coupling.

The present invention provides a single chip package using LGA coupling wherein the package has a short path for power supply and a ground, and transmits a signal in a coaxial shape or in a Co-Planar Waveguide guide (CPW) shape, so that parasitic inductance is minimized and performance of an RF chip does not deteriorate and a characteristic does not change as well as it enables low costs and miniaturization when mass-producing a product.

Particularly, the present invention is very useful for a millimeter wave band and may be used for implementing a system for a multi-frequency application in a system-on-package (SoP) such as a case where a millimeter wave band system is integrated in an integrated system of 2/5 GHz bands.

A package of the present invention couples a multi-layer substrate with a mainboard using a coupling pad for LGA coupling, and mounts one or a plurality of integrated circuit chips thereon.

In the present invention, a multi-layer substrate mounting an RF (millimeter wave) band antenna or transition between an integrated circuit chip and an antenna therein has an interconnection contact pad for LGA coupling with a mainboard, so that the multi-layer substrate is connected via simple soldering without an additional process.

In the present invention, a chip is connected with the multi-layer substrate via a flip-chip bump or a wire, and in case of an RF chip, GND vias are positioned in the neighborhood of a signal line bump, so that they play a role of a low loss transmission line such as a coaxial shape or a Co-Planar Waveguide guide (CPW).

The mainboard forms a cavity to provide a concave portion so that a chip attached on the multi-layer substrate may not bump into the mainboard. In addition, the mainboard may include an input end connected with a low frequency band antenna. In addition, the mainboard is used in the same meaning as a PCB in the present invention.

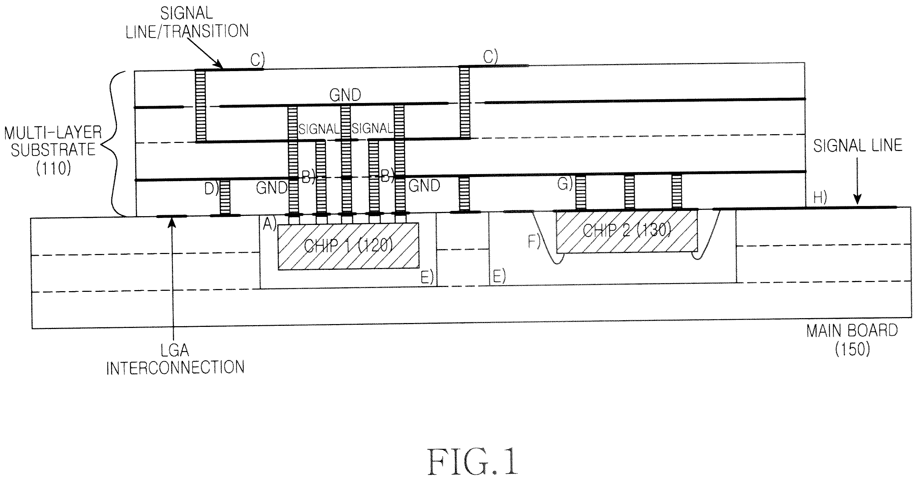

FIG. 1 illustrates a single chip package using LGA coupling according to an embodiment of the present invention.

Referring to FIG. 1, a signal, GND, and power of a chip 1 120 are connected with a multi-layer substrate 110 via flip-chip bonding (step A).

An RF signal is enclosed by two or more GND vias to maintain a coaxial cable shape or a CPW shape (step B).

A transition that can connect with an antenna or an external antenna is positioned in the uppermost layer of the multi-layer substrate 110 (step C).

In the multi-layer structure of the multi-layer substrate 110, power, GND, digital/IF signal, etc. are connected with the mainboard 150 (step D).

Chips 1, 2 120 and 130 are positioned in cavities in the mainboard 150 (step E).

Connection ends such as signal, GND, power of the chip 2 130 are connected with the multi-layer substrate 110 via wire bonding (step F).

The chip 2 130 is connected with GND mounted inside the multi-layer substrate 110 through a via of the multi-layer substrate 110 (step G).

Ends such as power, GND, digital/IF signal, etc. of the chip 2 130 are connected with the mainboard 150 (step H).

In the above single chip structure, a structure where the chip 1 120 and the multi-layer structure 110 are connected is used for an RF region. In addition, a structure where the chip 2 130 and the multi-layer structure 110 are connected is used for a low frequency region.

This is because the structure where the chip 1 120 and the multi-layer structure 110 are connected shows low performance deterioration for the RF region and even the low frequency region, and the structure where the chip 2 130 and the multi-layer structure 110 are connected shows relatively high performance deterioration for the RF region but shows low performance deterioration for the low frequency region.

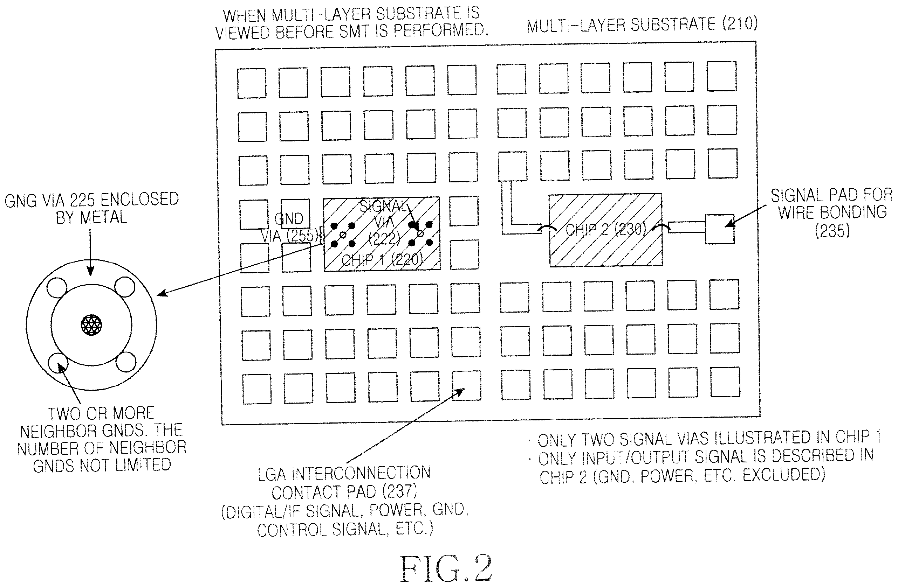

FIG. 2 illustrates a multi-layer substrate before SMT according to an embodiment of the present invention.

Referring to FIG. 2, a multi-layer substrate 210 before SMT is illustrated. The multi-layer substrate 210 includes a chip 1 220 and a chip 2 230 as an embodiment, but the number of chips is not limited in implementation.

As described above, the chip 2 230 may be connected with a signal pad 235 via the multi-layer substrate 210 and wire bonding.

In the chip 1 220, as an embodiment, two signal vias 227 are illustrated. The signal via 227 is enclosed by GNG vias 225, and the GNG vias 225 are enclosed by metal.

The number of GND vias 225 enclosing the signal via 227 is two or more per one signal via, and a maximum number of GND vias is not limited. The signal via 227 and the GND via 225 have a coaxial shape or a CPW shape, and have an advantage that performance deterioration is low in the RF region.

For connection using LGA coupling, an LGA interconnection contact pad 237 may be used for digital/IF signal, power, GND, control signal transmission of the chips 1, 2 220 and 230, and as described above, it may be used for coupling with the mainboard.

In an embodiment which will be described below, how the chip 2 is connected with the multi-layer substrate or the mainboard between the multi-layer substrate and the mainboard, and how a cavity is formed between the multi-layer substrate and the mainboard, and whether a heat sink is attached to the mainboard are described.

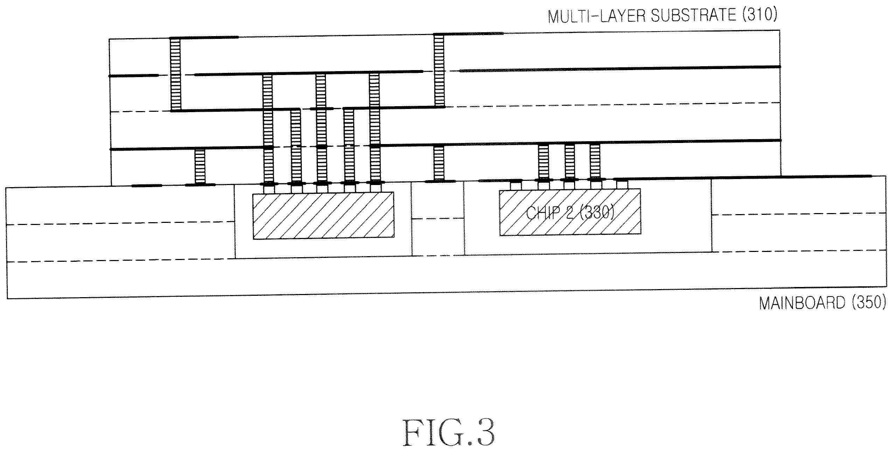

FIG. 3 is a view illustrating a connection structure of a mainboard and a multi-layer substrate according to an example not forming part of the present invention but useful for understanding it.

Referring to FIG. 3, a chip 2 330 is connected to the multi-layer substrate 310 using flip-chip bonding between the multi-layer substrate 310 and the mainboard 350. In FIG. 3, a cavity is positioned in the mainboard 350.

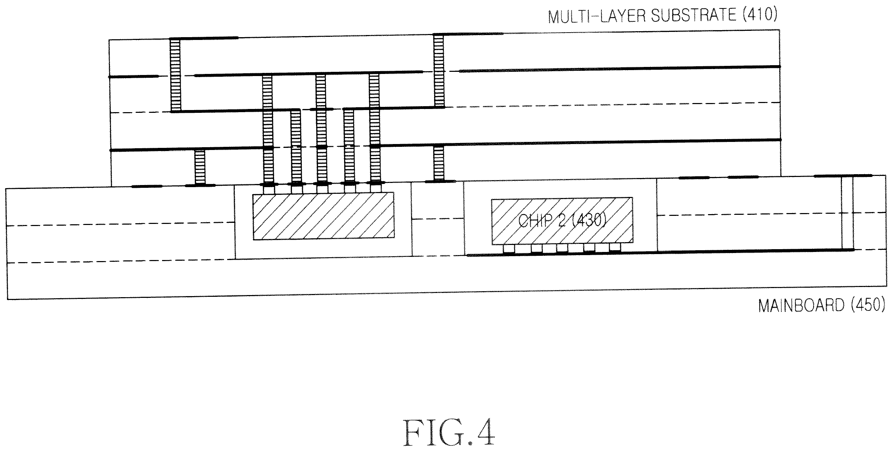

FIG. 4 is a view illustrating a connection structure of a mainboard and a multi-layer substrate according to another example not forming part of the present invention but useful for understanding it.

Referring to FIG. 4, a chip 2 430 is connected to the mainboard 450 using flip-chip bonding between the multi-layer substrate 410 and the mainboard 450. In this case, a cavity is positioned in the mainboard.

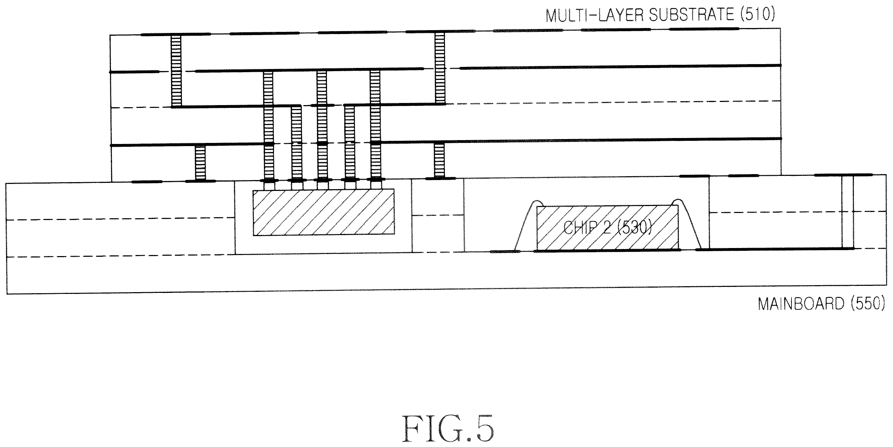

FIG. 5 is a view illustrating a connection structure of a mainboard and a multi-layer substrate according to further another example not forming part of the present invention but useful for understanding it.

Referring to FIG. 5, a chip 2 530 is connected to the mainboard 550 using wire bonding between the multi-layer substrate 510 and the mainboard 550. In this case, a cavity is positioned in the mainboard 550.

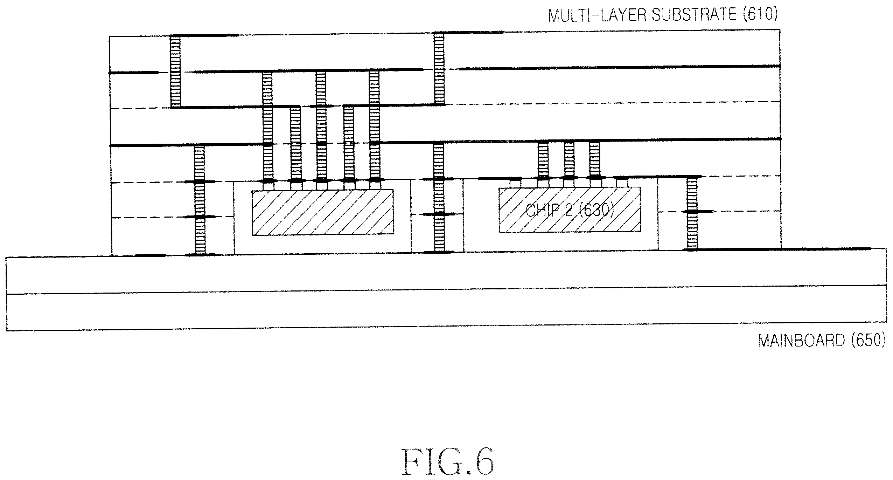

FIG. 6 is a view illustrating a connection structure of a mainboard and a multi-layer substrate according to still another example not forming part of the present invention but useful for understanding it.

Referring to FIG. 6, a chip 2 630 is connected to the multi-layer substrate 610 using flip-chip bonding between the multi-layer substrate and the mainboard 650. In this case, a cavity is positioned in the multi-layer substrate 610.

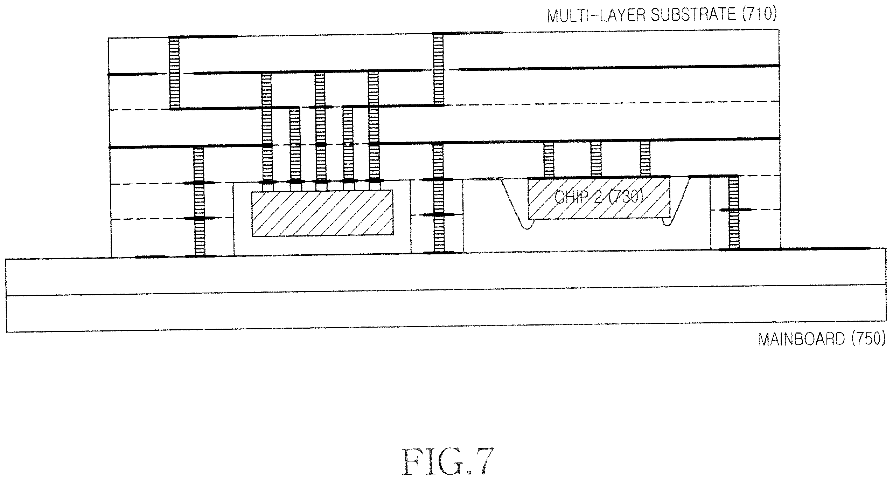

FIG. 7 is a view illustrating a connection structure of a mainboard and a multi-layer substrate according to yet another embodiment of the present invention.

Referring to FIG. 7, a chip 2 730 is connected to the multi-layer substrate 710 using wire bonding between the multi-layer substrate 710 and the mainboard 750. In this case, a cavity is positioned in the multi-layer substrate 710.

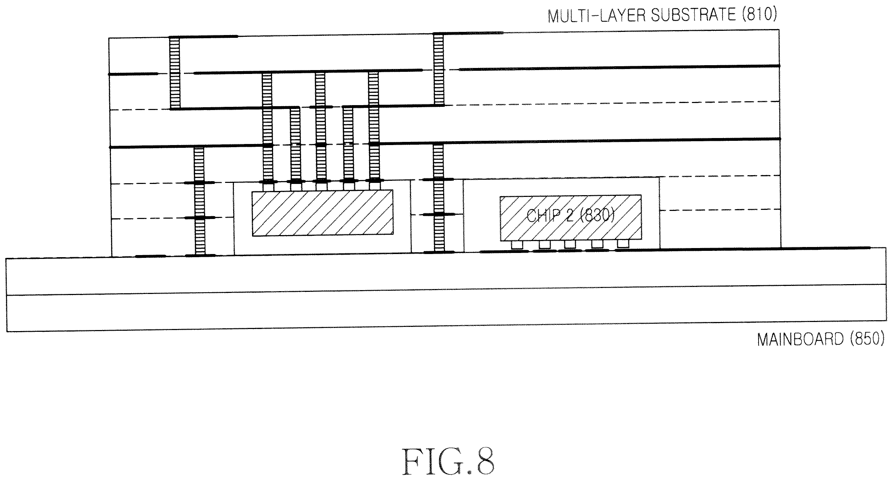

FIG. 8 is a view illustrating a connection structure of a mainboard and a multi-layer substrate according to yet still another example not forming part of the present invention but useful for understanding it.

Referring to FIG. 8, a chip 2 830 is connected to the mainboard 850 using flip-chip bonding between the multi-layer substrate 810 and the mainboard 850. In this case, a cavity is positioned in the multi-layer substrate 810.

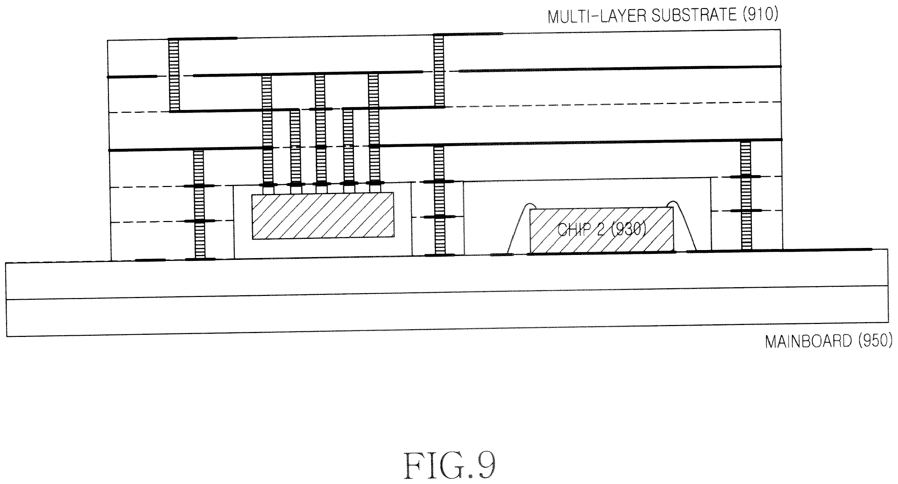

FIG. 9 is a view illustrating a connection structure of a mainboard and a multi-layer substrate according to yet further another example not forming part of the present invention but useful for understanding it.

Referring to FIG. 9, a chip 2 930 is connected to the mainboard 950 using wire bonding between the multi-layer substrate 910 and the mainboard 950. In this case, a cavity is positioned in the multi-layer substrate 910.

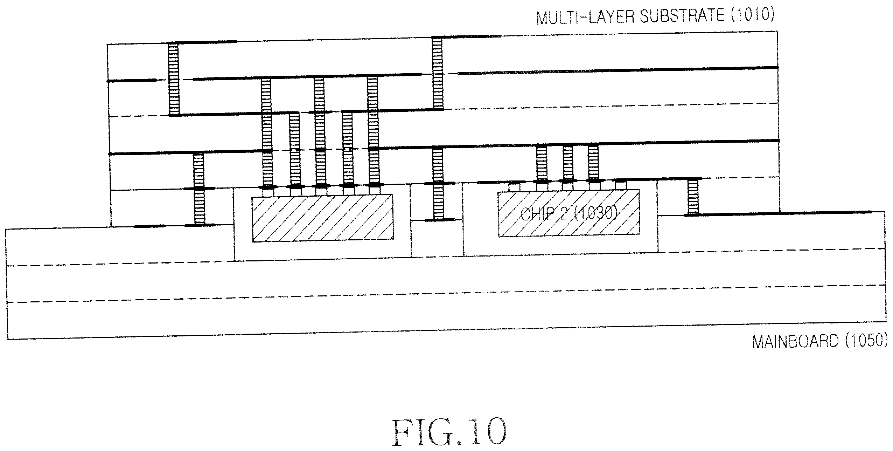

FIG. 10 is a view illustrating a connection structure of a mainboard and a multi-layer substrate according to still yet another example not forming part of the present invention but useful for understanding it.

Referring to FIG. 10, a chip 2 1030 is connected to the multi-layer substrate 1010 using flip-chip bonding between the multi-layer substrate 1010 and the mainboard 1050. In this case, a cavity is positioned in the multi-layer substrate 1010 and the mainboard 1050 together.

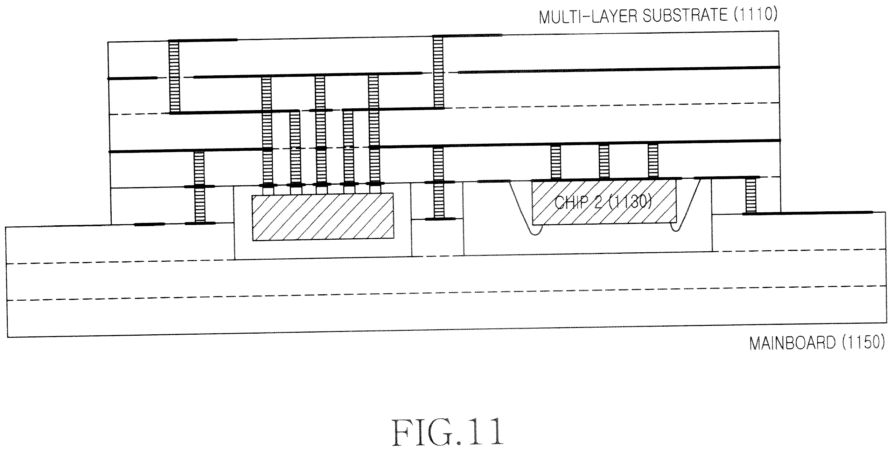

FIG. 11 is a view illustrating a connection structure of a mainboard and a multi-layer substrate according to still yet further another embodiment of the present invention.

Referring to FIG. 11, a chip 2 1130 is connected to the multi-layer substrate 1110 using wire bonding between the multi-layer substrate 1110 and the mainboard 1150. In this case, a cavity is positioned in the multi-layer substrate 1110 and the mainboard 1150 together.

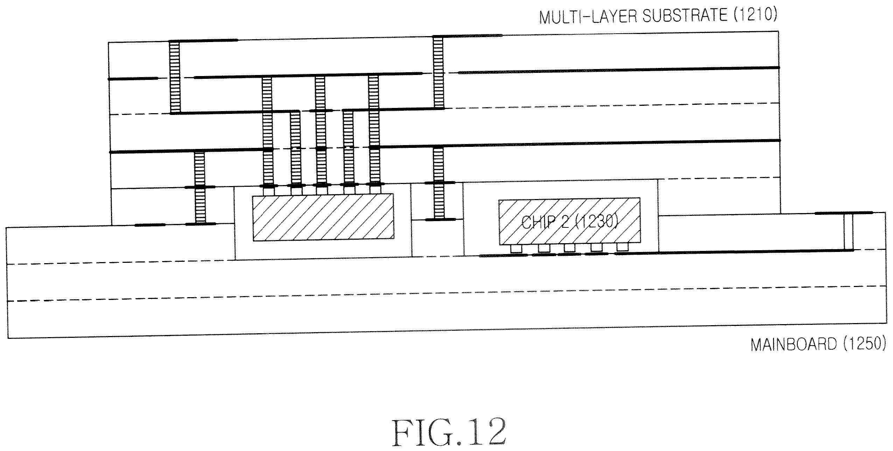

FIG. 12 is a view illustrating a connection structure of a mainboard and a multi-layer substrate according to yet still another example not forming part of the present invention but useful for understanding it.

Referring to FIG. 12, a chip 2 1230 is connected to the mainboard 1250 using flip-chip bonding between the multi-layer substrate 1210 and the mainboard 1250. In this case, a cavity is positioned in the multi-layer substrate 1210 and the mainboard 1250 together.

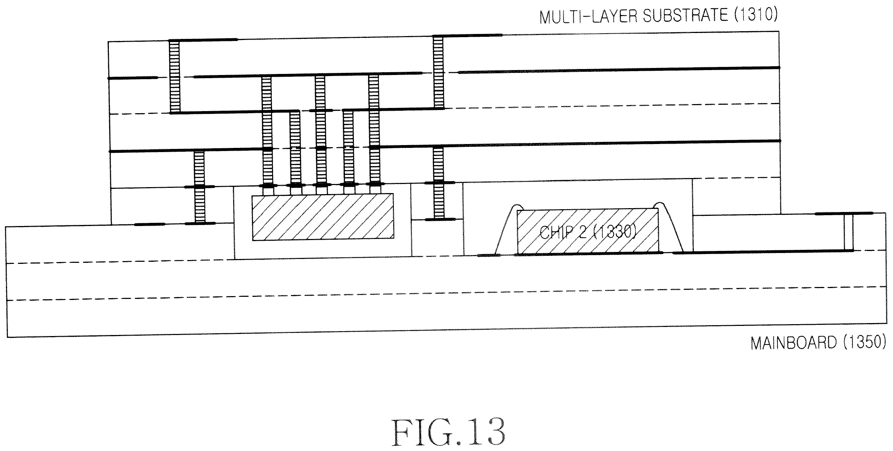

FIG. 13 is a view illustrating a connection structure of a mainboard and a multi-layer substrate according to yet still further another example not forming part of the present invention but useful for understanding it.

Referring to FIG. 13, a chip 2 1330 is connected to the mainboard 1350 using wire bonding between the multi-layer substrate 1310 and the mainboard 1350. In this case, a cavity is positioned in the multi-layer substrate 1310 and the mainboard 1350 together.

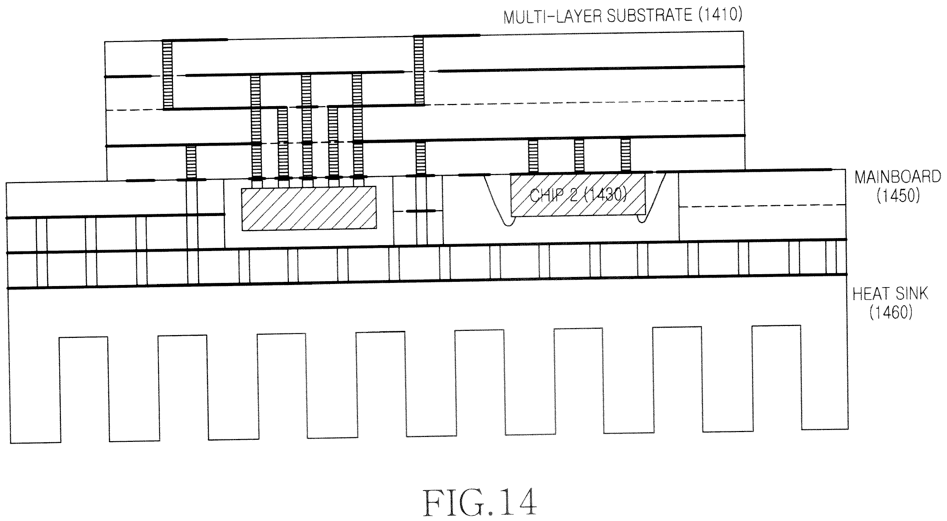

FIG. 14 is a view illustrating a connection structure of a mainboard and a multi-layer substrate according to yet another embodiment of the present invention.

Referring to FIG. 14, a chip 2 1430 is connected to the multi-layer substrate 1410 using wire bonding between the multi-layer substrate 1410 and the mainboard 1450. In this case, a cavity is positioned in the mainboard 1450.

In addition, a heat sink 1460 is attached to the mainboard 1450 to help heat emission of the mainboard 1450. The heat sink 1460 may be attached to all mainboards of FIGS. 3 to 13 to help heat emission.

Since the present invention does not require an additional process, it is advantageous in cost reduction, mass production, and miniaturization. Also, according to the present invention, since a power and GND path is short, parasitic inductance is small, so that an RF system performance is stable and it has an advantage in heat radiation and so the present invention is very advantageously applied to a portable terminal. Also, small-sized single integrated packaging of a millimeter wave band system or an integrated system of the millimeter wave band and a 2/5 GHz band is possible.

Although the invention has been shown and described with reference to certain exemplary embodiments thereof, it will be understood by those skilled in the art that various changes in form and details may be made therein without departing from the spirit and scope of the invention as defined by the appended claims and their equivalents. Therefore, the scope of the present invention should not be limited to the above-described embodiments but should be determined only by the appended claims.

## Claims

1. A chip package using Land Grid Array, LGA, coupling, the chip package comprising:
a multi-layer substrate (110, 210) comprising:
transmission lines of a vertical structure comprising a signal via surrounded by at least two ground vias to form a coaxial shape or a co-planar waveguide, CPW, shape,and
a coupling pad (237) at a lowermost substrate layer of the multi-layer substrate (110, 210),
a first integrated circuit, IC, (120, 220) directly connected to the signal via and the at least two ground vias by flip-chip bonding;
a second integrated circuit, IC, (130, 230) connected to a grounding, GND in the multi-layer substrate by wire bonding;
wherein a printed circuit board, PCB, (150) directly contacts the multi-layer substrate via the coupling pad (237) using the LGA coupling,
wherein at least part of the PCB (150) is concave to form a first cavity in which the first IC is included,
wherein another part of the PCB (150) is concave to form a second cavity in which the second IC is included, and
wherein an operating frequency of the first IC being in an RF region is higher than that of the second IC being in a low frequency region.

2. The chip package of claim 1, wherein the multi-layer substrate (110, 210) comprises at least one antenna for radiating a signal transmitted by the signal via in at least one layer of the multi-layer substrate (110, 210), or
the multi-layer substrate (110, 210) comprises at least one antenna coupling pad for connection with an external antenna for radiating a signal transmitted by the signal via in an uppermost layer of the substrate (110, 210).

3. The chip package of claim 1, further comprising a heat sink (1460) attached to the PCB (150, 1450), for emitting heat.

4. The chip package of claim 1, wherein the second IC is coupled on the lowermost substrate layer by the wire bonding.

5. The chip package of claim 1, wherein a power between the multi-layer substrate (110, 210) and the PCB (150) is connected via the LGA coupling.

6. A chip package using land grid array, LGA, coupling, the chip package comprising:
a multi-layer substrate (1110) comprising:
transmission lines of a vertical structure comprising a signal via surrounded by at least two ground vias to form a coaxial shape or a co-planar waveguide, CPW, shape, and
a coupling pad at a lowermost substrate layer of the multi-layer substrate,
a first integrated circuit, IC, directly connected to the signal via and the at least two ground vias by flip-chip bonding; and
a second integrated circuit, IC, (1130) connected to a grounding, GND, in the multi-layer substrate by wire bonding;
wherein a printed circuit board, PCB, (1150) directly contacts the multi-layer substrate via the coupling pad using the LGA coupling
wherein part of the PCB and part of the multi-layer substrate are concave to form together a first cavity in which the first IC is included
wherein another part of the PCB and another part of the multi-layer substrate are concave to form together a second cavity in which the second IC is included, and
wherein an operating frequency of the first IC chip being in an RF region is higher than an operating frequency of the second IC chip being in a low frequency region.

7. The chip package of claim 6, wherein the multi-layer substrate (1110) comprises at least one antenna for radiating a signal transmitted by the signal via in at least one layer of the multi-layer substrate, or the multi-layer substrate comprises at least one antenna coupling pad for connection with an external antenna for radiating a signal transmitted by the signal via in an uppermost layer of the substrate.

8. The chip package of claim 6, further comprising a heat sink (1460) attached to the PCB for emitting heat

9. The chip package of claim 6, wherein a power between the multi-layer substrate and the PCB is connected via the LGA coupling.

10. A chip package using land grid array, LGA, coupling, the chip package comprising:
a multi-layer substrate (710) comprising:
transmission lines of a vertical structure comprising a signal via surrounded by at least two ground vias to form a coaxial shape or a co-planar waveguide, CPW, shape, and
a coupling pad at a lowermost substrate layer of the multi-layer substrate,
a first integrated circuit, IC, directly connected to the signal via and the at least two ground vias by flip-chip bonding; and
a second integrated circuit, IC, (730) connected to a grounding, GND, in the multi-layer substrate by wire bonding;
wherein a printed circuit board, PCB, (750) directly contacting the multi-layer substrate via the coupling pad using the LGA coupling
wherein part of the multi-layer substrate is concave to form a first cavity in which the first IC is included,
wherein another part of the multi-layer substrate is concave to form a second cavity in which the second IC is included, and
wherein an operating frequency of the first IC chip being in an RF region is higher than an operating frequency of the second IC chip being in an low frequency region.

11. The chip package of claim 10, wherein the multi-layer substrate comprises at least one antenna for radiating a signal transmitted by the signal via in at least one layer of the multi-layer substrate, or the multi-layer substrate comprises at least one antenna coupling pad for connection with an external antenna for radiating a signal transmitted by the signal via in an uppermost layer of the substrate.

12. The chip package of claim 10, further comprising a heat sink (1460) attached to the PCB for emitting heat.

13. The chip package of claim 10, wherein a power between the multi-layer substrate and the PCB is connected via the LGA coupling.

## Patentansprüche

1. Ein Chippaket, das eine Landgitter-Array-, LGA-, Kopplung verwendet, das Chippaket umfassend:
ein mehrschichtiges Substrat (110, 210), umfassend:
Übertragungsleitungen einer vertikalen Struktur, die einen Signaldurchgang umfassen, der von mindestens zwei Erdungsdurchgängen umgeben ist, um eine koaxiale Form oder eine koplanare Wellenleiterform, CPW, zu bilden, und
eine Kopplungsfläche (237) auf einer untersten Substratschicht des mehrschichtigen Substrats (110, 210),
eine erste integrierte Schaltung, IC, (120, 220), die durch Flip-Chip-Bonding direkt mit dem Signaldurchgang und den mindestens zwei Erdungsdurchgängen verbunden ist;
eine zweite integrierte Schaltung, IC, (130, 230), die mit einer Erdung, GND, in dem mehrschichtigen Substrat durch Drahtbonding verbunden ist;
wobei eine gedruckte Leiterplatte, PCB, (150) das mehrschichtige Substrat über die Kopplungsfläche (237) unter Verwendung der LGA-Kopplung direkt kontaktiert,
wobei zumindest ein Teil der PCB (150) konkav ist, um einen ersten Hohlraum zu bilden, in dem der erste IC enthalten ist,
wobei ein anderer Teil der Leiterplatte (150) konkav ist, um einen zweiten Hohlraum zu bilden, in dem der zweite IC enthalten ist, und
wobei eine Betriebsfrequenz des ersten IC, der in einem HF-Bereich liegt, höher ist als die des zweiten IC, der in einem Niederfrequenzbereich liegt.

2. Das Chippaket nach Anspruch 1, wobei das mehrschichtige Substrat (110, 210) mindestens eine Antenne umfasst, um ein Signal, welches vom Signaldurchgang in mindestens einer Schicht des mehrschichtigen Substrats (110, 210) übertragen wird, auszustrahlen, oder
das mehrschichtige Substrat (110, 210) mindestens eine Antennenkopplungsfläche zur Verbindung mit einer externen Antenne umfasst, um ein Signal, welches vom Signaldurchgang in einer obersten Schicht des Substrats (110, 210) übertragen wird, auszustrahlen.

3. Das Chippaket nach Anspruch 1, ferner umfassend einen Kühlkörper (1460), der an der Leiterplatte (150, 1450) angebracht ist, um Wärme abzugeben.

4. Das Chippaket nach Anspruch 1, wobei der zweite IC auf der untersten Substratschicht durch das Drahtbonding gekoppelt ist.

5. Das Chippaket nach Anspruch 1, wobei eine Stromversorgung zwischen dem mehrschichtigen Substrat (110, 210) und der Leiterplatte (150) über die LGA-Kopplung verbunden ist.

6. Ein Chippaket, das eine Landgitter-Array-, LGA-, Kopplung verwendet, das Chippaket umfassend:
ein mehrschichtiges Substrat (1110) umfassend:
Übertragungsleitungen einer vertikalen Struktur, die einen Signaldurchgang umfassen, der von mindestens zwei Erdungsdurchgängen umgeben ist, um eine koaxiale Form oder eine koplanare Wellenleiterform, CPW, zu bilden, und
eine Kopplungsfläche auf einer untersten Substratschicht des mehrschichtigen Substrats,
eine erste integrierte Schaltung, IC, die durch Flip-Chip-Bonding direkt mit dem Signaldurchgang und den mindestens zwei Erdungsdurchgängen verbunden ist; und
eine zweite integrierte Schaltung, IC, (1130), die mit einer Erdung, GND, in dem mehrschichtigen Substrat durch Drahtbonding verbunden ist;
wobei eine gedruckte Leiterplatte, PCB, (1150) das mehrschichtige Substrat über die Kopplungsfläche unter Verwendung der LGA-Kopplung direkt kontaktiert,
wobei ein Teil der Leiterplatte und ein Teil des mehrschichtigen Substrats konkav sind, um zusammen einen ersten Hohlraum zu bilden, in dem der erste IC enthalten ist,
wobei ein anderer Teil der Leiterplatte und ein anderer Teil des mehrschichtigen Substrats konkav sind, um zusammen einen zweiten Hohlraum zu bilden, in dem der zweite IC enthalten ist, und
wobei eine Betriebsfrequenz des ersten IC-Chips, der in einem HF-Bereich liegt, höher ist als eine Betriebsfrequenz des zweiten IC-Chips, der in einem Niederfrequenzbereich liegt.

7. Das Chippaket nach Anspruch 6, wobei das mehrschichtige Substrat (1110) mindestens eine Antenne umfasst, um ein Signal, welches vom Signaldurchgang in mindestens einer Schicht des mehrschichtigen Substrats (110, 210) übertragen wird, auszustrahlen, oder das mehrschichtige Substrat mindestens eine Antennenkopplungsfläche zur Verbindung mit einer externen Antenne umfasst, um ein Signal, welches vom Signaldurchgang in einer obersten Schicht des Substrats übertragen wird, auszustrahlen.

8. Das Chippaket nach Anspruch 6, ferner umfassend einen Kühlkörper (1460), der an der Leiterplatte angebracht ist, um Wärme abzugeben.

9. Das Chippaket nach Anspruch 6, wobei eine Stromversorgung zwischen dem mehrschichtigen Substrat und der Leiterplatte über die LGA-Kopplung verbunden ist.

10. Ein Chippaket, das eine Landgitter-Array-, LGA-, Kopplung verwendet, das Chippaket umfassend:
ein mehrschichtiges Substrat (710) umfassend:
Übertragungsleitungen einer vertikalen Struktur, die einen Signaldurchgang umfassen, der von mindestens zwei Erdungsdurchgängen umgeben ist, um eine koaxiale Form oder eine koplanare Wellenleiterform, CPW, zu bilden, und
eine Kopplungsfläche auf einer untersten Substratschicht des mehrschichtigen Substrats,
eine erste integrierte Schaltung, IC, die durch Flip-Chip-Bonding direkt mit dem Signaldurchgang und den mindestens zwei Erdungsdurchgängen verbunden ist; und
eine zweite integrierte Schaltung, IC, (730), die mit einer Erdung, GND, in dem mehrschichtigen Substrat durch Drahtbonding verbunden ist;
wobei eine gedruckte Leiterplatte, PCB, (750) das mehrschichtige Substrat über die Kopplungsfläche unter Verwendung der LGA-Kopplung direkt kontaktiert,
wobei ein Teil der des mehrschichtigen Substrats konkav sind, um einen ersten Hohlraum zu bilden, in dem der erste IC enthalten ist,
wobei ein anderer Teil des mehrschichtigen Substrats konkav sind, um einen zweiten Hohlraum zu bilden, in dem der zweite IC enthalten ist, und
wobei eine Betriebsfrequenz des ersten IC-Chips, der in einem HF-Bereich liegt, höher ist als eine Betriebsfrequenz des zweiten IC-Chips, der in einem Niederfrequenzbereich liegt.

11. Das Chippaket nach Anspruch 10, wobei das mehrschichtige Substrat mindestens eine Antenne umfasst, um ein Signal, welches vom Signaldurchgang in mindestens einer Schicht des mehrschichtigen Substrats übertragen wird, auszustrahlen, oder das mehrschichtige Substrat mindestens eine Antennenkopplungsfläche zur Verbindung mit einer externen Antenne umfasst, um ein Signal, welches vom Signaldurchgang in einer obersten Schicht des Substrats übertragen wird, auszustrahlen.

12. Das Chippaket nach Anspruch 10, ferner umfassend einen Kühlkörper (1460), der an der Leiterplatte angebracht ist, um Wärme abzugeben.

13. Das Chippaket nach Anspruch 10, wobei eine Stromversorgung zwischen dem mehrschichtigen Substrat und der Leiterplatte über die LGA-Kopplung verbunden ist.

## Revendications

1. Boîtier à puce utilisant un couplage à matrice de plots (Land Grid Array), LGA, le boîtier à puce comprenant :
un substrat multicouche (110, 210) comprenant:
des lignes de transmission d'une structure verticale comprenant un passage de signal entouré d'au moins deux passages de masse pour former une forme coaxiale ou une forme de guide d'ondes coplanaire, CPW, et
un plot de couplage (237) au niveau d'une couche de substrat la plus basse du substrat multicouche (110, 210),
un premier circuit intégré, IC, (120, 220) directement connecté au passage de signal et au moins aux deux passages de masse par une liaison flip-chip;
un second circuit intégré, IC, (130, 230) connecté à une mise à la terre, GND, dans le substrat multicouche par liaison filaire;
dans lequel une carte de circuit imprimé, PCB, (150) entre directement en contact avec le substrat multicouche par le biais du plot de couplage (237) en utilisant le couplage LGA,
dans lequel au moins une partie du PCB (150) est concave pour former une première cavité dans laquelle le premier CI est inclus,
dans lequel une autre partie du PCB (150) est concave pour former une seconde cavité dans laquelle le second CI est inclus, et
dans lequel une fréquence de fonctionnement du premier CI se trouvant dans une région RF est supérieure à celle du second CI se trouvant dans une région basse fréquence.

2. Boîtier à puce selon la revendication 1, dans lequel le substrat multicouche (110, 210) comprend au moins une antenne pour rayonner un signal transmis par le passage de signal dans au moins une couche du substrat multicouche (110, 210), ou
le substrat multicouche (110, 210) comprend au moins un plot de couplage d'antenne pour une connexion avec une antenne externe pour rayonner un signal transmis par le passage de signal dans une couche supérieure du substrat (110, 210).

3. Boîtier à puce de la revendication 1, comprenant en outre un dissipateur thermique (1460) fixé à la carte de circuit imprimé (150, 1450), pour émettre de la chaleur.

4. Boîtier à puce selon la revendication 1, dans lequel le second circuit intégré est couplé sur la couche de substrat la plus basse par la liaison par fil.

5. Boîtier à puce selon la revendication 1, dans lequel une alimentation entre le substrat multicouche (110, 210) et le PCB (150) est connectée par le biais du couplage LGA.

6. Boîtier à puce utilisant un couplage LGA (Land Grid Array), le boîtier à puce comprenant:
un substrat multicouche (1110) comprenant:
des lignes de transmission d'une structure verticale comprenant une via de signal entourée d'au moins deux passages de masse pour former une forme coaxiale ou une forme de guide d'ondes coplanaire, CPW, et
un plot de couplage au niveau d'une couche de substrat la plus basse du substrat multicouche,
un premier circuit intégré, IC directement connecté au passage de signal et au moins aux deux passages de masse par liaison flip-chip; et
un second circuit intégré, IC, (1130) connecté à une mise à la terre, GND, dans le substrat multicouche par liaison filaire;
dans lequel une carte de circuit imprimé, PCB, (1150) entre directement en contact avec le substrat multicouche par le biais du plot de couplage (207) en utilisant le couplage LGA.
dans lequel une partie du circuit imprimé et une partie du substrat multicouche sont concaves pour former ensemble une première cavité dans laquelle le premier circuit intégré est inclus;
dans lequel une autre partie du circuit imprimé et une autre partie du substrat multicouche sont concaves pour former une seconde cavité dans laquelle le second circuit intégré est inclus, et
dans lequel une fréquence de fonctionnement de la première puce de circuit intégré se trouvant dans une région RF est supérieure à une fréquence de fonctionnement de la seconde puce de circuit intégré se trouvant dans une région basse fréquence.

7. Ensemble de puces selon la revendication 6,
dans lequel le substrat multicouche (1110) comprend au moins une antenne pour rayonner un signal transmis par le passage de signal dans au moins une couche du substrat multicouche ou le substrat multicouche comprend au moins un plot de couplage d'antenne pour une connexion avec une antenne externe pour rayonner un signal transmis par le passage de signal dans une couche supérieure du substrat.

8. Boîtier à puce de la revendication 6, comprenant en outre un dissipateur thermique (1460) fixé à la carte de circuit imprimé pour émettre de la chaleur.

9. Boîtier à puce selon la revendication 6, dans lequel une alimentation entre le substrat multicouche et le PCB est connectée via le couplage LGA.

10. Boîtier à puce utilisant un couplage LGA (Land Grid Array), le boîtier à puce comprenant:
un substrat multicouche (710) comprenant:
des lignes de transmission d'une structure verticale comprenant une via de signal entourée d'au moins deux passages de masse pour former une forme coaxiale ou une forme de guide d'ondes coplanaire, CPW, et
un plot de couplage au niveau d'une couche de substrat la plus basse du substrat multicouche,
un premier circuit intégré, IC, directement connecté au via de signal et aux au moins deux passages de masse par une liaison flip-chip; et
un second circuit intégré, IC, (730) connecté à une mise à la terre, GND,
dans le substrat multicouche par liaison filaire;
dans lequel une carte de circuit imprimé, PCB, (750) en contact direct avec le substrat multicouche via le plot de couplage (207) en utilisant le couplage LGA,
dans lequel une partie du substrat multicouche est concave pour former une première cavité dans laquelle le premier circuit intégré est inclus,
dans lequel une autre partie du substrat multicouche est concave pour former une seconde cavité dans laquelle le second CI est inclus, et
dans lequel une fréquence de fonctionnement de la première puce de circuit intégré se trouvant dans une région RF est supérieure à une fréquence de fonctionnement de la seconde puce de circuit intégré se trouvant dans une région basse fréquence.

11. Boîtier à puce selon la revendication 10, dans lequel le substrat multicouche comprend au moins une antenne pour rayonner un signal transmis par le passage de signal dans au moins une couche du substrat multicouche ou le substrat multicouche comprend au moins un plot de couplage d'antenne pour une connexion avec une antenne externe pour rayonner un signal transmis par le passage de signal dans une couche supérieure du substrat.

12. Boîtier à puce selon la revendication 10, comprenant en outre un dissipateur thermique (1460) fixé à la carte de circuit imprimé pour émettre de la chaleur.

13. Boîtier à puce selon la revendication 10, dans lequel une alimentation entre le substrat multicouche et le PCB est connectée via le couplage LGA.
